# DEMANDE DE BREVET EUROPEEN

(11) **EP 1 347 515 A1**
(43) Date de publication de la demande: **24.09.2003**
(21) Numéro de dépôt: 03354027.9
(22) Date de dépôt: 21.03.2003
(51) Int. Cl.: H01L 27/02, H01L 27/112, H01L 23/544

(54) **Différenciation de puces au niveau d'un réticule**

(30) Priorité: 22.03.2002 FR 0203619
(71) Demandeur: STMicroelectronics S.A., 92120 Montrouge (FR)
(72) Inventeur: Wuidart, Luc, 83910 Pourrieres (FR); Bouton, Guilhem, 13790 Peynier (FR); Bardouillet, Michel, 13790 Rousset (FR)
(74) Mandataire: Thibon, Laurent

(57) **Abrégé**

L'invention concerne un procédé de différenciation de circuits intégrés reproduisant des fonctions identiques par stockage d'un code binaire dans un élément de mémorisation non volatil prévu dans chaque circuit, consistant à prévoir, pour chaque circuit d'un même réticule, une implantation sélective de dopants de son élément de mémorisation qui est différente des implantations sélectives des dopants des éléments de mémorisation des autres circuits.

## Description

La présente invention concerne la différenciation de puces de circuits intégrés réalisées dans une même tranche semiconductrice (wafer).

Pour fabriquer des circuits intégrés, on réalise, dans une tranche semiconductrice, de très nombreux ensembles distincts ou puces de circuits intégrés. D'une puce à une autre, les circuits peuvent être fonctionnellement identiques (homogènes) ou réaliser des fonctions différentes (hétérogènes).

Il peut être souhaitable de différencier des circuits réalisant une même fonction (homogènes). Pour ce faire, on utilise généralement un identifiant de puce ou quantité secrète sous la forme d'un code binaire mémorisé dans une mémoire non volatile. Pour rendre cette mémoire inaccessible à un utilisateur, on doit figer le code à la fabrication. On utilise alors une mémoire à lecture seulement, formée dans la même puce que le circuit ainsi identifié. Les cellules mémoire correspondantes comportent au moins un transistor de type MOS. Lors de la conception du circuit, on supprime la grille de certains transistors de cellules mémoire pour figer l'état (passant ou bloqué) de ces transistors et programmer ainsi les cellules mémoire concernées. Un inconvénient est que cela modifie alors l'aspect physique de la puce (on peut détecter optiquement la présence ou l'absence des grilles sur les zones d'isolant de champ qui séparent les zones actives des transistors). Le code mémorisé peut alors être reconstruit à partir de cette détection. Or, lorsque l'on souhaite pourvoir une puce d'un identifiant en fabrication, c'est souvent que l'on souhaite préserver le secret de cet identifiant.

La présente invention vise à proposer un procédé de différenciation de circuits intégrés fonctionnellement identiques et réalisés dans une même tranche semiconductrice qui pallie les inconvénients des procédés connus.

La présente invention vise plus particulièrement à permettre le stockage d'un code binaire en fabrication, sans que ce code soit détectable par une observation optique de la puce.

Pour atteindre ces objets et d'autres, la présente invention prévoit un procédé de différenciation de circuits intégrés reproduisant des fonctions identiques par stockage d'un code binaire dans un élément de mémorisation non volatil prévu dans chaque circuit, le procédé consistant à prévoir, pour chaque circuit d'un même réticule, au moins une implantation sélective de dopants de son élément de mémorisation qui est différente des implantations sélectives des dopants des éléments de mémorisation des autres circuits.

Selon un mode de mise en oeuvre de la présente invention, une seule implantation sélective de dopant est modifiée d'un circuit à un autre dans un même réticule.

Selon un mode de mise en oeuvre de la présente invention, le réticule est formé en lui incorporant au moins une géométrie définissant les éléments de mémorisation qui est différente d'un circuit à un autre sur le même réticule.

Selon un mode de mise en oeuvre de la présente invention, l'élément de mémorisation est constitué de cellules élémentaires qui comprennent chacune au moins un transistor MOS.

Selon un mode de mise en oeuvre de la présente invention, on modifie, de circuit en circuit, l'implantation de régions de drain et de source des transistors MOS.

Selon un mode de mise en oeuvre de la présente invention, on modifie, de circuit en circuit, l'implantation des grilles des transistors MOS.

Selon un mode de mise en oeuvre de la présente invention, des cellules élémentaires de l'élément de mémorisation comprennent des résistances.

Selon un mode de mise en oeuvre de la présente invention, on modifie, de circuit en circuit, l'implantation des résistances.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente, en vue de dessus partielle et schématique, une tranche semiconductrice lors d'une étape intermédiaire de formation de circuits intégrés selon la présente invention ;
la figure 2 est un agrandissement d'une partie de la figure 1 ;
la figure 3 est un agrandissement d'une partie de la figure 2 ;
la figure 4 est un schéma électrique, partiel et schématique, d'un mode de réalisation d'un circuit de mémorisation d'un code binaire selon l'invention ;
la figure 5A représente, partiellement et schématiquement, une cellule élémentaire du circuit de la figure 4, non programmée selon un mode de réalisation de la présente invention ;
la figure 5B représente, partiellement et schématiquement, une cellule élémentaire du circuit de la figure 4, programmée dans un premier état selon un mode de réalisation de la présente invention ; et
la figure 5C représente, partiellement et schématiquement, une cellule élémentaire du circuit de la figure 4, programmée dans un second état selon un mode de réalisation de la présente invention.

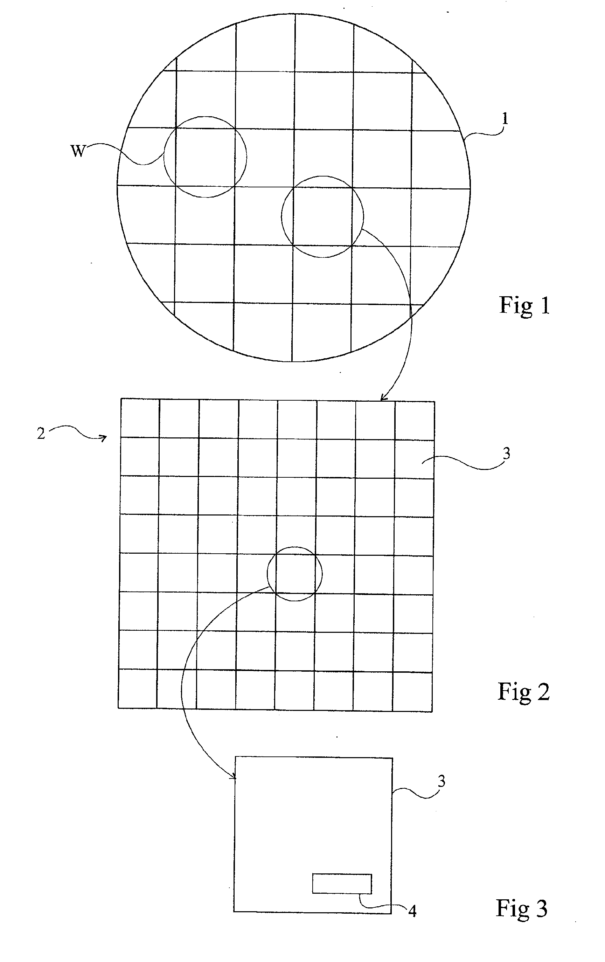

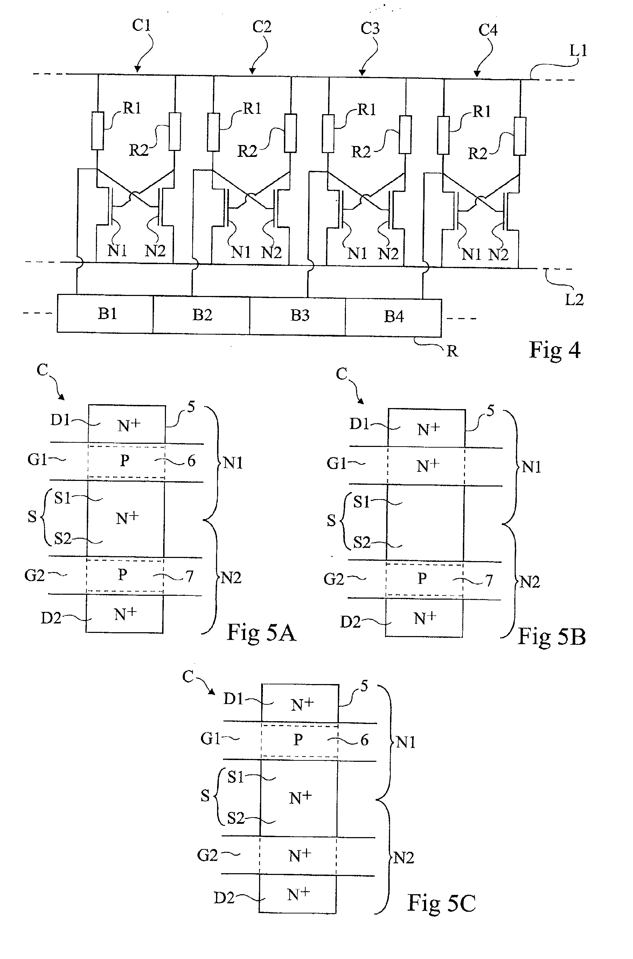

Par souci de clarté, de mêmes éléments sont désignés par de mêmes références aux différentes figures. De plus, les figures 1, 2, 3, 5A, 5B et 5C sont tracées sans respect d'échelle. En outre, seuls les étapes et éléments nécessaires à la compréhension de l'invention ont été représentés et seront décrits par la suite. En particulier, les étapes de formation des circuits intégrés n'ont pas été détaillées quand elles sont classiques. De plus et par exemple, en figure 4, le dispositif de lecture n'est pas représenté et, en figure 5, toutes les métallisations et connexions ne sont pas représentées.

Une caractéristique de la présente invention est de mémoriser un code binaire, de différenciation de puces de circuits intégrés réalisant une même fonction, en modifiant une implantation de définition de régions spécifiques de cellules élémentaires de la mémoire (à lecture seulement) contenant le code.

Comme cela sera détaillé ci-après, des cellules élémentaires de mémoires ROM comprennent au moins un transistor de type MOS. Des régions de drain et de source du transistor sont définies dans la tranche semiconductrice, par implantation sélective de dopants appropriés.

La figure 1 illustre, en vue de dessus partielle et schématique, une tranche semiconductrice 1, lors d'une étape intermédiaire de fabrication des circuits intégrés. Dans cette étape, on forme un masque d'implantation destiné à définir, dans la tranche 1, au moins des régions spécifiques de cellules élémentaires des mémoires ROM dans lesquelles sont stockés des codes d'identification des circuits. L'opération de masquage consiste à déposer, sur toute la tranche, une résine photosensible puis à soumettre des régions spécifiques de la résine à un éclairement U.V. Selon le type de résine (positive ou négative), les parties éclairées - insolées - de la résine ou non sont ensuite éliminées sélectivement de façon à découvrir partiellement le semiconducteur, par exemple du silicium, constituant la tranche 1. Le dessin de la résine forme, au niveau du circuit, un masque d'implantation reproduisant le dessin interposé, lors de l'insolation, entre la source d'éclairement et la tranche 1. Par la suite, et sauf précision contraire, on désignera par masque, l'élément interposé optiquement, nommé également réticule.

En pratique, l'insolation est effectuée au moyen d'un dispositif présentant une fenêtre d'éclairement W de dimensions inférieures à celles de la tranche 1. Pour conférer à la résine le dessin voulu, on déplace pas à pas la tranche 1 à la verticale de la fenêtre d'exposition W et on interpose, entre celle-ci et la tranche 1, un réticule comportant des parties opaques au rayonnement de la fenêtre et des parties transparentes à celui-ci. Comme l'illustre la figure 1, la tranche 1 est déplacée de façon que toute sa surface passe à un moment donné sous la fenêtre d'éclairement. Par souci de clarté, on considère dans la suite un cas dans lequel la tranche est homogène, c'est-à-dire que le même réticule est utilisé pour insoler toute la plaquette.

La figure 2 représente un détail de la figure 1, à savoir un réticule 2 (masque) d'exposition de la fenêtre W. Le réticule 2 va présenter des dimensions telles que plusieurs puces de circuits intégrés seront insolées simultanément. Par souci de clarté, on considère dans la suite un cas dans lequel le réticule est homogène, c'est-à-dire que les puces comprennent chacune un même circuit. Par exemple, le réticule 2 correspond à huit rangées et huit colonnes, soit 64 puces. En pratique, avec la miniaturisation croissante des circuits intégrés, un réticule peut comprendre plusieurs centaines de circuits intégrés.

La figure 3 représente un détail du réticule de la figure 2, à savoir, un des circuits intégrés 3 qu'il définit. Chaque puce 3 comprend selon l'invention une mémoire ROM 4 destinée à stocker un code binaire d'identification du circuit en cours de réalisation. La mémoire 4 est constituée d'une matrice de cellules élémentaires de préférence d'une seule ligne ou colonne.

La figure 4 représente, partiellement et schématiquement, le schéma électrique équivalent d'un mode de réalisation possible d'une mémoire de stockage d'un code binaire selon l'invention. Pour simplifier, la figure 4 représente seulement quatre cellules C1, C2, C3 et C4. Toutefois, selon l'invention, le nombre de cellules de la mémoire est, de préférence, choisi en fonction du nombre de circuits contenus dans le réticule afin de générer, avec les bits de la mémoire, autant de codes distincts qu'il y a de circuits sur le réticule. Par souci de clarté, on s'attachera ci-après à décrire un mode de réalisation de la présente invention en relation avec une seule cellule C. On notera toutefois dès à présent que tout ce qui sera exposé en relation avec cette cellule s'applique également à toutes les autres cellules de la mémoire.

Au sens de la présente invention, la cellule élémentaire C peut être de tout type connu comportant au moins un transistor MOS. Par exemple, la cellule C est une paire différentielle de deux transistors N1 et N2 connectés en parallèle entre deux lignes d'alimentation L1 et L2, en étant chacun en série avec une résistance R1, R2. Les résistances R1 et R2 sont obtenues par implantation sélective de dopants dans du silicium (polycristallin ou non). On suppose que les transistors N1 et N2 sont, par exemple, à canal N. La grille d'un transistor donné N1, N2 est connectée au drain de l'autre transistor N2, N1, respectivement. On considère arbitrairement que le drain du transistor N1, commun à la grille du transistor N2, constitue une borne de lecture de la donnée binaire B stockée dans la cellule C. Selon ce mode de réalisation, l'état de sortie de la cellule C dépend du transistor N1 ou N2 qui devient conducteur le premier suite à l'application d'un front positif d'alimentation sur la ligne L1. Le déséquilibre entre les deux transistors de chaque cellule C provient de la programmation propre à l'invention qui sera exposée par la suite en relation avec les figures 5A, 5B et 5C. Dans l'exemple de la figure 4, la lecture des cellules s'effectue en parallèle. En variante, on pourra prévoir une lecture série des cellules et/ou une matrice à plusieurs lignes et/ou colonnes. L'exploitation d'une mémoire selon l'invention une fois programmée fait appel à des techniques classiques de lecture selon le type de cellules mémoire (un ou plusieurs transistors) et leur agencement.

Par exemple, les sorties respectives des cellules sont reliées aux entrées d'un registre R de stockage temporaire du code lors d'une lecture. Le registre R est, de préférence, réinitialisé après chaque lecture afin de ne pas laisser subsister le code, hors des périodes où l'application en a besoin. Cela va dans le sens d'une sécurisation accrue du code. En tout état de cause, le registre R est vidé lors de l'extinction du circuit par disparition de l'alimentation (non représentée).

Selon un autre mode de réalisation (non représenté), chaque cellule mémoire comprend, entre les lignes L1 et L2, un seul transistor MOS et, le cas échéant, une résistance. La lecture s'effectue alors en série, au moyen d'un comparateur avec une référence, le transistor servant d'élément de sélection (et de programmation en l'absence de résistance).

Un avantage du mode de réalisation de la figure 4 est qu'un simple changement d'état d'un signal appliqué sur la ligne L1 (ou L2) provoque à la fois l'alimentation et la lecture du code stocké dans la mémoire.

Selon la présente invention, la programmation d'une cellule est obtenue en modifiant l'étendue d'implantation de définition des régions de source et de drain de ses transistors N1 et N2.

La figure 5A illustre un mode de réalisation d'une cellule C de la figure 4 non programmée. Les deux transistors N1 et N2 sont réalisés côte à côte dans une même zone active 5 de la tranche 1. Au stade de fabrication auquel on s'est placé dans les figures 1, 2 et 3, des régions individuelles de drain/source D1 et D2 sont implantées simultanément, respectivement en haut et en bas de la figure 5A. En même temps, une région commune S de source/drain S1, S2 des transistors N1 et N2 est implantée, au centre de la figure 5A. On considère que la tranche 1 et donc la zone active 5 est dopée d'un premier type de conductivité, par exemple P. Les dopants implantés pour définir les régions de drain D1 et D2 et de source S, sont du type de conductivité complémentaire, par exemple N. Ensuite, à un stade ultérieur de la fabrication sont formées, pour chaque transistor N1 et N2, des grilles G1 et G2. Comme l'illustre la figure 5A, les étendues des régions de drain D1 et D2 et de source S sont telles que chaque grille G1 et G2 définit, dans la zone active 5, une région de canal 6, 7 séparant la source commune S d'une région individuelle de drain D1, D2, respectivement.

Selon l'invention, la programmation est effectuée en modifiant les étendues d'implantation, par exemple, des régions de source et de drain d'un seul des transistors N1 et N2 de chaque cellule.

La figure 5B illustre un mode de programmation, dans une cellule C de la figure 4, d'une donnée B dans un premier état binaire considéré ici comme "0". La figure 5B diffère de la figure 5A en ce que l'étendue de l'une des régions individuelles de drain/source de l'un des transistors, par exemple la région D1 du transistor N1, est modifiée. Par exemple, la région modifiée D1 est étendue de façon qu'elle atteigne et se confonde avec la région commune de source S. Alors, la grille G1 du transistor N1 traverse la région active 5 à la verticale de la région continue D1-S. Par contre, la grille G2 de l'autre transistor N2 définit toujours un canal 7 dans la zone active 5 de type P. Lors d'un accès en lecture, c'est-à-dire lors de l'application d'un front positif d'alimentation sur la ligne L1, le transistor N1 devient alors plus rapidement conducteur que le transistor N2. En effet, il se comporte comme une résistance simple et il ne lui est pas nécessaire qu'un canal (6 en figures 5A et 5C) se crée, au contraire du transistor N2. Le transistor N1 recopie alors virtuellement sur sa sortie, c'est-à-dire son drain D1, un niveau de référence basse présent sur la ligne L2. La grille G2 du transistor N2 étant connectée à cette sortie, la recopie tend à le bloquer dans un état ouvert qui verrouille, au niveau de son drain D2, le niveau haut du front positif présent sur la ligne L1. Le drain D2 étant connecté à la grille G1, le déséquilibre de conduction est verrouillé et la cellule C fournit au registre R une donnée stable dans un premier état binaire considéré, par convention, comme "0".

La figure 5C illustre un mode de programmation dans une cellule C de la figure 4 d'une donnée B dans un second état binaire considéré ici comme "1". La figure 5C diffère de la figure 5A en ce que, par rapport à la figure 5B, l'étendue de l'autre D2 des régions individuelles de drain/source de l'autre N2 des transistors de la cellule C est étendue de façon qu'elle atteigne et se confonde avec la région commune de source S. Alors, le canal 6 du transistor N1 est maintenu en place alors que le canal 7 du transistor N2 est supprimé et remplacé par une région D2-S continue fortement conductrice. Lors d'un accès en lecture, les comportements des transistors N1 et N2 sont alors inversés. On verrouille donc le drain D1 du transistor N1, c'est-à-dire la sortie de la cellule C, dans un état complémentaire du précédent considéré ici comme "1".

En modifiant de la façon décrite précédemment en relation avec les figures 5B et 5C l'étendue des régions spécifiques de définition des transistors constituant la cellule élémentaire d'une mémoire ROM, on obtient un stockage d'un code binaire d'autant de bits que de cellules élémentaires, et cela de façon indécelable. En effet, toutes les cellules élémentaires réalisées comportent maintenant des grilles et sont réalisées dans des zones actives. Lors d'une observation optique, toutes les cellules de la mémoire de différenciation sont donc identiques, quel que soit leur état programmé. De plus, deux puces distinctes (avec des codes différents) seront optiquement identiques.

Selon l'invention, lors d'une étape d'implantation sélective de dopants, au moins dans la partie mémoire de la puce, on reproduit un dessin maître élémentaire correspondant à une cellule standard telle que décrite précédemment en relation avec la figure 5A. Ce dessin maître est reproduit autant de fois que nécessaire à l'intérieur du réticule 2 (figure 2) de façon à permettre une définition simultanée des régions à implanter de toutes les puces 3 (figures 2 et 3) qu'il est nécessaire de pouvoir identifier au moyen du code binaire. Ensuite, à l'intérieur du réticule 2, l'étendue des diverses régions spécifiques de drain et/ou de source est modifiée d'une cellule à l'autre à l'intérieur d'une même puce et d'une puce à l'autre de façon distincte, de façon à mémoriser dans chaque puce un code différent.

L'individualisation des niveaux d'implantation s'effectue par simple modification des géométries des circuits reproduits dans le réticule. En pratique, on utilise des moyens informatiques pour définir ces masques sous formes de fichiers.

La formation d'un masque est obtenue par combinaison de couches de dessins issues d'une base de données graphiques définissant le circuit. Le masque d'implantation sur lequel agit l'invention est formé en incorporant, aux couches de dessins définissant ce masque, une géométrie définissant les zones de cellules mémoire à programmer.

Selon l'invention, au lieu de reproduire un même circuit sur tout le réticule (masque), on modifie, de circuit en circuit, la géométrie définissant les implantations des cellules. On obtient alors autant de circuits différents que de positions sur le réticule. L'invention n'ajoute en pratique aucun niveau de masque, et ne requiert qu'une modification de programmation d'un niveau existant.

Une fois le réticule ainsi réalisé, il est interposé entre la fenêtre d'exposition et la tranche semiconductrice 1 de la façon décrite précédemment et toute la tranche 1 est insolée pas à pas.

A titre d'exemple, si on considère un réticule couvrant 256 puces, on prévoit une mémoire de huit bits pour différencier les 256 puces les unes par rapport aux autres. Toutefois, plus le nombre de puces, donc de codes, par réticule est élevé, plus l'invention présente un intérêt en termes de différenciation.

Bien entendu, la présente invention est susceptible de diverses variantes et modifications qui apparaîtront à l'homme de l'art. En particulier, une programmation par déséquilibre de conduction selon la présente invention d'un élément de chaque cellule élémentaire de stockage de l'identifiant de puce peut être effectuée de très nombreuses façons.

Ainsi, dans le mode de réalisation selon la présente invention décrit en relation avec la figure 5, on a considéré qu'un tel résultat est obtenu en modifiant l'extension d'une région de drain/source individuelle d'un transistor, de façon à supprimer son canal. Toutefois, le même codage peut être obtenu en supprimant, c'est-à-dire en ne dopant pas, la région individuelle de drain/source de l'autre transistor.

Par ailleurs, tant dans le mode de réalisation décrit en relation avec la figure 5 que dans celui qui précède, la programmation selon l'invention consiste à déséquilibrer les résistances d'accès aux transistors des cellules programmées. Comme cela a été décrit en relation avec la figure 4, chaque transistor N1, N2 de chaque cellule C peut être associé à une résistance respective R1, R2. Le stockage d'un code binaire de différenciation peut être effectué selon la présente invention en modifiant un masque d'implantation de ces résistances R1, R2.

De plus, au lieu de modifier la conductivité par modification de la résistance d'accès, on peut déséquilibrer les conditions de commande. En effet, dans de nombreuses filières, les grilles G1, G2 des transistors sont dopées simultanément de façon à accroître leur conductivité. Selon l'invention, on peut modifier le masque d'implantation de façon à n'implanter qu'une seule prédéterminée des deux grilles des cellules. Le transistor dont la grille est non dopée présentera alors un retard à la fermeture qui permet de stocker et verrouiller une donnée binaire d'une façon similaire à ce qui a été décrit précédemment.

En outre, on a considéré jusqu'à présent qu'un seul masque d'implantation est modifié. On pourrait toutefois prévoir d'en modifier plusieurs. On pourra par exemple combiner un déséquilibre de résistance d'accès par modification d'extension d'une région implantée dans la tranche et/ou un déséquilibre de résistance d'accès par modification d'extension d'une résistance indépendante, et/ou un déséquilibre des conditions de commande.

L'homme de l'art saura adapter les types de conductivité et les niveaux de dopage à une filière particulière. En particulier, l'invention n'a été décrite au moyen de transistors MOS à canal N qu'à titre d'exemple non limitatif. L'homme de l'art comprendra que la présente invention s'applique également à des cellules utilisant des transistors MOS à canal P. La lecture s'effectuera alors en utilisant un front négatif sur la ligne L1 (resp. positif sur la ligne L2).

De façon similaire, l'homme de l'art saura adapter et choisir les masques d'implantation à modifier, pour obtenir un codage binaire, en fonction de la structure d'une cellule élémentaire.

## Revendications

1. Procédé de différenciation de circuits intégrés (3) reproduisant des fonctions identiques par stockage d'un code binaire dans un élément de mémorisation non volatil (4) prévu dans chaque circuit, **caractérisé en ce qu'**il consiste à prévoir, pour chaque circuit d'un même réticule, au moins une implantation sélective de dopants de son élément de mémorisation qui est différente des implantations sélectives des dopants des éléments de mémorisation des autres circuits.

2. Procédé selon la revendication 1, **caractérisé en ce qu'**une seule implantation sélective de dopant est modifiée d'un circuit à un autre dans un même réticule.

3. Procédé selon la revendication 1 ou 2, **caractérisé en ce que** le réticule est formé en lui incorporant au moins une géométrie définissant les éléments de mémorisation (4) qui est différente d'un circuit à un autre sur le même réticule.

4. Procédé selon l'une quelconque des revendications 1 à 3, **caractérisé en ce que** l'élément de mémorisation (4) est constitué de cellules élémentaires (C1, C2, C3, C4) qui comprennent chacune au moins un transistor MOS (N1, N2).

5. Procédé selon les revendications 3 et 4, **caractérisé en ce qu'**on modifie, de circuit en circuit, l'implantation de régions de drain (D1, D2) et de source (S1, S2, S) des transistors MOS (N1, N2).

6. Procédé selon les revendications 3 et 4, **caractérisé en ce qu'**on modifie, de circuit en circuit, l'implantation des grilles (G1, G2) des transistors MOS (N1, N2).

7. Procédé selon l'une quelconque des revendications 1 à 6, **caractérisé en ce que** des cellules élémentaires (C1, C2, C3, C4) de l'élément de mémorisation (4) comprennent des résistances (R1, R2).

8. Procédé selon la revendication 7 dans son rattachement aux revendications 3 et 4, **caractérisé en ce qu'**on modifie, de circuit en circuit, l'implantation des résistances (R1, R2).
